# EUROPEAN PATENT SPECIFICATION

(11) **EP 0 715 319 B1**
(45) Date of publication and mention of the grant of the patent: **19.04.2000**
(21) Application number: 95118665.9
(22) Date of filing: 27.11.1995
(51) Int. Cl.: H01F 1/00, G01R 33/16

(54) **Use of nonmagnetic materials for sample containers and holders for a magnetometric apparatus**
Verwendung nichtmagnetischer Materialien für Probenbehälter und -halterungen in magnetometrischen Vorrichtungen
Utilisation de matériaux non-magnétiques pour récipients pour échantillons et porte-récipients utilisés dans des appareils magnétométriques

(30) Priority: 02.12.1994 JP 32400894
(43) Date of publication of application: 05.06.1996
(73) Proprietor: YKK CORPORATION, Chiyoda-ku, Tokyo (JP)
(72) Inventor: Kazama, Noriaki, Sendai-shi, Miyagi-ken (JP)
(74) Representative: Patentanwälte Leinweber & Zimmermann

(56) References cited:
- DE-A- 2 213 181
- US-A- 5 294 268

## Description

### BACKGROUND OF THE INVENTION

### 1. Field of the Invention:

This invention relates to nonmagnetic materials so formed as to exhibit substantially null magnetic susceptibility and to sample containers and sample holders or supporting members made thereof and used for magnetometric apparatus or magnetometers and in particular to the use of specific nonmagnetic materials as a sample container or a sample supporting member for a magnetometric apparatus.

### 2. Description of the Prior Art:

Devices for measuring very feeble magnetism have been developed recently. For example, superconducting quantum interference devices (SQUID), vibrating sample magnetometers (VSM), alternating force magnetometers (AFM), etc. have been put to actual use. Some, if not all, of these high-performance magnetometric devices are capable of measuring even very feeble magnetization. The SQUID fluxmeters which utilize the superconducting technique are even capable of measuring magnetic fields (of the order of 10⁻⁷ to 10⁻⁹ T) emanating from human bodies. Studies devoted to harnessing these devices for the diagnosis of human bodies, the inspection of electronic circuits, and the like are under way.

Various means are available for the determination of magnetization. The devices mentioned above assume forms of their own. In the determination of magnetization by means of the VSM, for example, the intensity of magnetization of a sample in the form of a thin film, powder, solid, or liquid can be found by setting the sample in place in a sample container, magnetizing the sample with a magnetizer, vibrating a sample supporting bar inserted into the sample container at prescribed frequency and amplitude in the vertical direction thereby giving rise to an induced voltage in a detecting coil disposed closely to the magnetized sample, and measuring the amplitude of this induced voltage.

Measuring means varies with the subject and the purpose of measurement. When any of the devices mentioned above is used for the determination of feeble magnetization, the sample must be prevented to the fullest possible extent from being affected by extraneous magnetism to ensure accuracy of the determination. In the VSM, for example, since the sample container and the sample supporting bar themselves are inevitably magnetized by a magnetic field being applied, the influence of this magnetization does not deserve to be disregarded when the sample has notably small magnetic susceptibility.

The sample container and the supporting member which are used for the magnetometer, therefore, are made of a substance of the smallest possible magnetic susceptibility. Generally, such a diamagnetic material as acrylic resin or quartz which shows the magnetic susceptibility, χ , of a small negative magnitude is used.

For the purpose of precluding the sample container and other parts from exerting such adverse influences on the measurement, the practice of effecting measurement of magnetization in the absence of a sample besides the measurement performed on the sample which is placed in the container and then computing the effect of the magnetization solely of the sample on the basis of the difference between the results of the two measurements has been in vogue. This method, therefore, is at a disadvantage in requiring much time for the two measurements which must be made whenever the sample container is replaced. Particularly in the observation of such a phenomenon as, for example, the transformation point of magnetism which appears only once, the transition point is generally searched for as the temperature is raised meanwhile. The investigation of such a delicate phenomenon as the primary transition point, however, has the problem that the determination cannot be attained with high accuracy because the results of determination tend to vary with the conditions set for the determination.

For the reasons given above, it is desirable that the sample container and other parts exert no influence on the measurement of magnetization, namely they have χ = 0 for their magnetic susceptibility.

Incidentally, all the substances are magnetically polarized more or less in a magnetic field. They are magnetic materials in a sense and none of them has null magnetic susceptibility in the strict sense of the word. Every substance, in responding to magnetism, manifests magnetic susceptibility of a positive or a negative magnitude. This magnitude depends on the magnetic field and the temperature besides the kind of substance itself. The substances having positive magnitudes of magnetic susceptibility are called paramagnetic materials and the substances having negative magnitudes of magnetic susceptibility diamagnetic materials. All the substances belong to these categories.

Further, US-A-5,294,268 discloses a non-magnetic material consisting of a combination of a paramagnetic material and diamagnetic material wherein manganese is used as the paramagnetic material and copper is used as a diamagnetic material.

Still further DE-A-22 13 181 discloses the sheathing of a paramagnetically susceptible conductor with a diamagnetic material in order to compensate the paramagnetic susceptibility of a base wire material with the diamagnetically susceptible sheath material.

### SUMMARY OF THE INVENTION

It is a primary object of the present invention, therefore, to provide a nonmagnetic material for use as a sample container or a sample supporting member for a magnetometric apparatus and exhibiting substantially null magnetic susceptibility, χ , and, therefore, exerting no adverse effect on the determination of magnetization of a sample and enabling the magnetization solely of the sample to be determined by one measurement with high accuracy.

To accomplish the objects mentioned above, the present invention provides the use of a nonmagnetic material as specified in appended claim 1.

### BRIEF DESCRIPTION OF THE DRAWINGS

Other objects, features, and advantages of the invention will become apparent from the following description taken together with the drawings, in which:
Fig. 1 is a graph showing the relation between the intensity of a magnetic field, H, and the magnetization, M, of a varying magnetic material used in the present invention, wherein the slope of each line in the graph represents magnetic susceptibility, χ ;
Fig. 2 is a schematic diagram showing the construction of one example of an apparatus for producing a nonmagnetic material by an extruding process in accordance with the present invention;
Fig. 3 is a schematic diagram showing the construction of one example of an apparatus for producing a nonmagnetic material by a laminate rolling process in accordance with the present invention;
Fig. 4 is a schematic diagram showing the construction of one example of an apparatus for producing a nonmagnetic material by a sputtering process in accordance with the present invention;
Fig. 5 is a graph showing the relation between the magnetization per unit weight of the alloy of Al_{94.3}Bi_{5.7} (atomic %) and the intensity of a magnetic field;
Fig. 6 is a graph showing the relation between the magnetization per unit weight of metallic aluminum and the intensity of a magnetic field; and
Fig. 7 is a graph showing the relation between the magnetization per unit weight of metallic bismuth and the intensity of a magnetic field.

### DETAILED DESCRIPTION OF THE INVENTION

All the substances, no matter whether they are simple elements or compounds, are magnetically polarized more or less in a magnetic field and, therefore, assume positive or negative proper values for magnetic susceptibility as remarked above. The present inventor, after taking notice of the fact that magnetizations of opposite signs offset each other and then analyzing various substances for magnetic susceptibility, has found that a nonmagnetic material can be produced by alloying, dispersing, mixing, or laminating a paramagnetic material and a diamagnetic material in a ratio such that their opposite magnitudes of magnetic susceptibility will be offset and substantially nulled.

When the nonmagnetic material produced as described above and allowed to manifest nulled magnetic susceptibility is used for the sample container and the sample holder or supporting member in a highly accurate magnetometric apparatus, these parts of the apparatus exert no adverse effect on the measurement of magnetization of a sample and enable the apparatus to determine the magnetization solely of the sample in one measurement with high accuracy. This material, therefore, realizes a magnetometric apparatus which operates with high accuracy and high efficiency.

As stated above, all the substances manifest positive or negative magnitudes of magnetic susceptibility. The magnetic susceptibility has such dependence on temperature that the magnitude thereof found at room temperature is different from that at an elevated temperature. In the measurement of changes of magnetization of a sample due to changes of temperature, therefore, changes in magnetic susceptibility of the sample container and the supporting member inevitably affect largely the changes of magnetization of the sample. When the sample container and the supporting member are made of the nonmagnetic material of the present invention which has nulled magnetic susceptibility, χ = 0, however, they show no change of magnetic susceptibility in spite of a change of temperature. Thus, the changes of magnetization due to changes of temperature solely of the sample can be measured.

The inventor has ascertained as a result of a study that Mg and Al both manifest such small magnitudes of magnetic susceptibility as satisfy χ > 0 and, therefore, can be utilized advantageously as paramagnetic materials in the present invention. The nonmagnetic material to be used according to the present invention is appropriately produced by using at least one of Mg and Al as a paramagnetic component and at least one member selected from the group consisting of Zn, Ga, Ge, Ag, Bi, In, Al₂O₃, and SiO₂ as a diamagnetic component in the nonmagnetic material mentioned above.

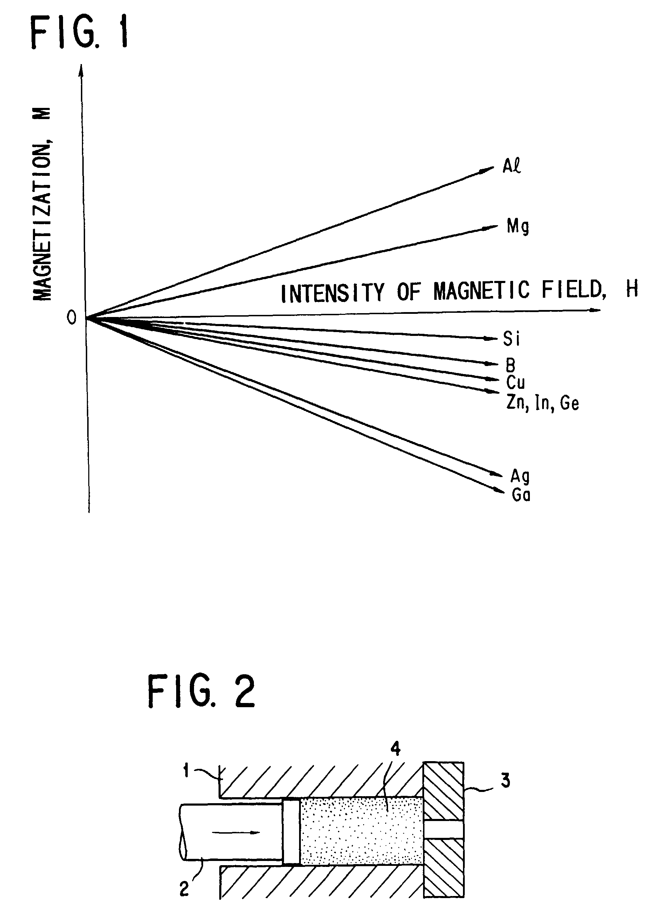

The magnitudes of magnetic susceptibility which the inventor has experimentally determined of the paramagnetic materials and the diamagnetic materials enumerated above are shown graphically in Fig. 1 and numerically in Table 1 given hereinafter. Fig. 1 is a graph showing the relation between the intensity of a magnetic field, H, and the magnetization, M, of a varying material. The slope of each line appearing in the graph represents magnetic susceptibility, χ .

The nonmagnetic material to be used according to the present invention can be manufactured by such methods as alloying, dispersing, mixing, or laminating a paramagnetic material and a diamagnetic material, for example.

Specifically, the mixing or extruding method produces the nonmagnetic material by the steps of preparing a paramagnetic material and a diamagnetic material each in a powdered form, thoroughly mixing the powdered materials in a gravimetric ratio calculated to impart to the resultant mixture nulled magnetic susceptibility, compressing the produced mixture, and extruding the compressed mixture.

The laminating method produces the nonmagnetic material by the steps of preparing a paramagnetic material and a diamagnetic material each in the form of thin sheets, alternately superposing the thin sheets in a ratio calculated to impart to the resultant stack nulled magnetic susceptibility, and subjecting the stack to pressure laminating by means of a rolling mill or the like. The alloying method or dispersing method may produce the nonmagnetic material on a substrate by vaporizing simultaneously a paramagnetic material and a diamagnetic material at a prescribed ratio as by means of vacuum deposition or sputtering, for example.

In the alloying and the dispersing method, by preparing a paramagnetic material and a diamagnetic material at a prescribed ratio in a molten state, the resultant alloy or dispersion is allowed to assume nulled magnetic susceptibility because the two materials undergo uniform two-phase separation. If the alloy or the dispersion so produced happens to involve separation of a precipitate such as, for example, compounds of the relevant materials, the compounds will possibly vary the magnetic susceptibility of the resultant alloy or the dispersion and prevent it from being nulled (χ = 0). In this case, the alloying or the dispersion must be implemented with the two materials used in a ratio calculated to cancel the magnetization of the precipitate as well.

The nonmagnetic material contemplated for the use of the present invention is characterized, as described above, by having a paramagnetic material and a diamagnetic material incorporated therein in a ratio calculated so that the respective magnitudes of magnetic susceptibility thereof will be offset and substantially nulled. When the nonmagnetic material of the present invention is molded or shaped to produce the sample container and the sample holder or supporting member for a magnetometric apparatus and this apparatus is used for the determination of magnetization of a sample, the apparatus avoids being affected by the otherwise possible magnetization of these parts and proves advantageous in enabling the effect solely of the sample to be observed by one measurement with high accuracy.

Further, since the nonmagnetic material has substantially nulled magnetic susceptibility and, therefore, has no dependence on the magnetic field and on the temperature as well, changes of temperature of the sample container etc. result in no change in the nulled magnetic susceptibility. The magnetometric apparatus, therefore, allows the change of magnetic susceptibility due to a change of temperature solely of a sample disposed in the container to be observed by one measurement.

The modern high-quality magnetometric devices are capable of measuring such extremely feeble magnetization as is exerted by such component parts as a sample container. When they use conventional parts, they are inevitably affected by the possible magnetization of such parts. Owing to the development of such parts of devices made of the nonmagnetic material of the present invention, however, the high-quality magnetometric devices are now allowed to display their true merits. The use of the sample container and the supporting member which are made of the nonmagnetic material of the present invention enables the magnetometric determination to be carried out with further improved accuracy and efficiency.

Now, the present invention will be described specifically below with reference to working examples.

The magnetic materials which were used in the following examples were experimentally determined to assume the magnitudes of magnetic susceptibility shown in Table 1 below.

**Table 1**

| Quality | Element | Magnetic susceptibility, χ |
|---|---|---|
| Paramagnetic material | Mg | + 10 × 10⁻⁶(emu/mol) |
| | Al | + 17 × 10⁻⁶(emu/mol) |
| | | + 0.61× 10⁻⁶(emu/g) |
| Diamagnetic material | Zn | - 10 × 10⁻⁶(emu/mol) |
| | Ga | - 22 × 10⁻⁶(emu/mol) |
| | Ge | - 10 × 10⁻⁶(emu/mol) |
| | Ag | - 20 × 10⁻⁶(emu/mol) |
| | Bi | - 280 × 10⁻⁶(emu/mol) |
| | In | - 10 × 10⁻⁶(emu/mol) |
| | Al₂O₃ | - 0.34× 10⁻⁶(emu/g) |
| | SiO₂ | - 0.50× 10⁻⁶(emu/g) |

Nonmagnetic materials were produced by using a paramagnetic material and a diamagnetic material selected and used in a ratio calculated, based on the data of Table 1, so that the respective magnitudes of magnetic susceptibility thereof would be offset and substantially nulled. The ratios of these materials used herein were as shown in Table 2.

**Table 2**

| Run No. | Paramagnetic material (weight %) | Diamagnetic material (weight %) |
|---|---|---|
| 1 | Mg(50) | Zn (50) |
| 2 | Mg(50) | In (50) |
| 3 | Mg(96.6) | Bi ( 3.4) |
| 4 | Mg(66) | Ag (34) |
| 5 | Mg(68.7) | Ga (31.3) |
| 6 | Al(94.3) | Bi ( 5.7) |
| 7 | Al(37) | Zn (63) |
| 8 | Al(56) | Ga (44) |
| 9 | Al(35) | Al₂O₃ (65) |
| 10 | Al(45) | SiO₂ (55) |

### Example 1:

As shown in Fig. 2, a powder 4 produced by mixing a paramagnetic material and a diamagnetic material in a stated gravimetric ratio to give nulled magnetic susceptibility to the produced mixture was charged in a container 1, compressed and solidified and simultaneously extruded through a die 3 by the use of a stem 2. Consequently, a nonmagnetic material of the shape of a rod was produced.

### Example 2:

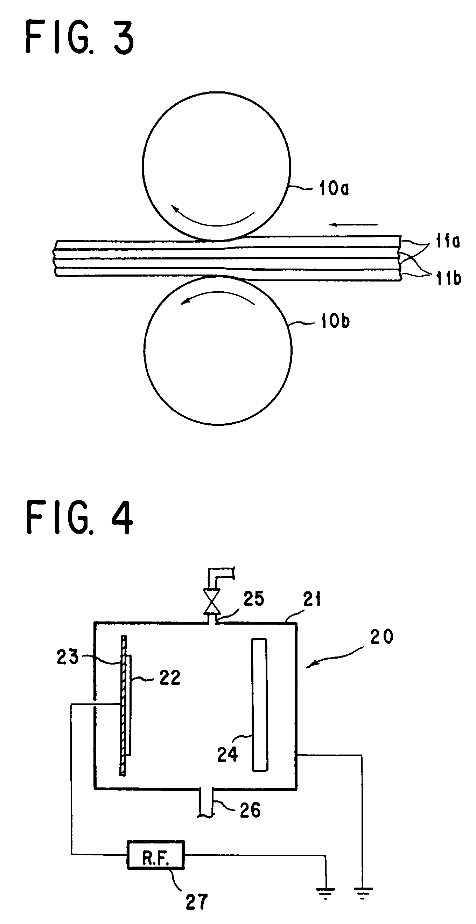

Fig. 3 depicts manufacture of a nonmagnetic material by lamination. In this case, thin plates 11a made of a paramagnetic material and thin plates 11b made of a diamagnetic material were alternately superposed at a stated ratio to give nulled magnetic susceptibility to the produced stack and the stack was passed between pressure rolls 10a and 10b to effect pressure lamination thereof. Consequently, a laminated nonmagnetic plate was formed.

### Example 3:

For the purpose of forming a nonmagnetic film on a substrate, a sputtering device 20 constructed as shown in Fig. 4 was used. Targets 22 of a paramagnetic material and of a diamagnetic material respectively of stated weights were attached to a supporting plate 23 disposed in a vacuum container 21. The supporting plate 23 was rotated during the sputtering and a nonmagnetic material was continuously deposited on a substrate 24. A high-frequency power source 27 was used for the operation of sputtering. In the diagram, the reference numeral 25 stands for a suction pipe and 26 for an exhaust pipe.

### Example 4:

An ingot of a composition of Al_{94.3} Bi_{5.7} (atomic %) was produced by subjecting aluminum and bismuth each of a purity of 99.99% to high-frequency melting in an argon atmosphere.

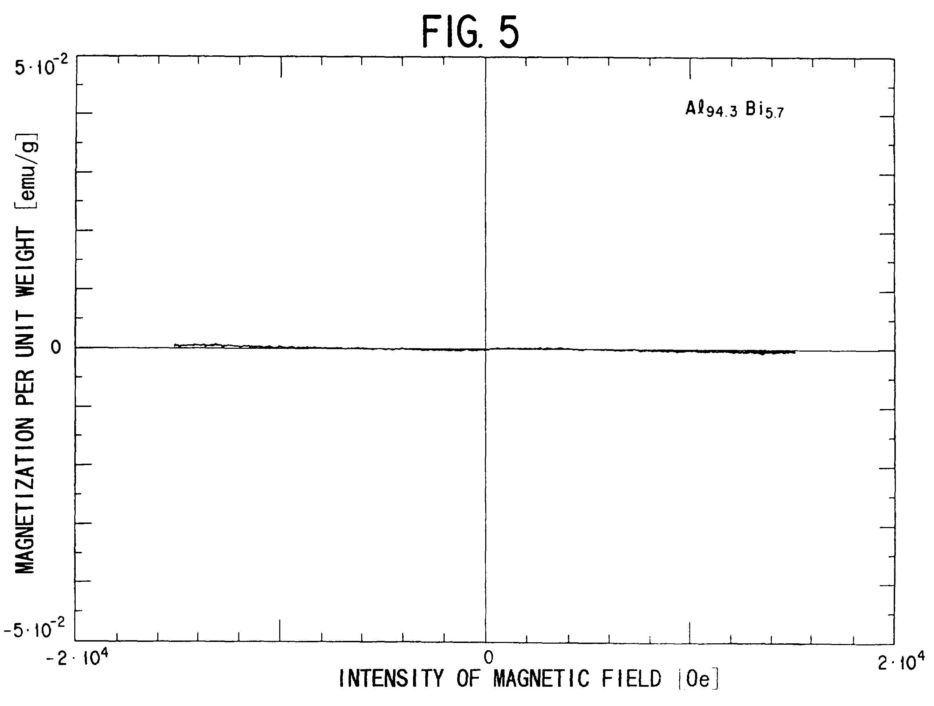

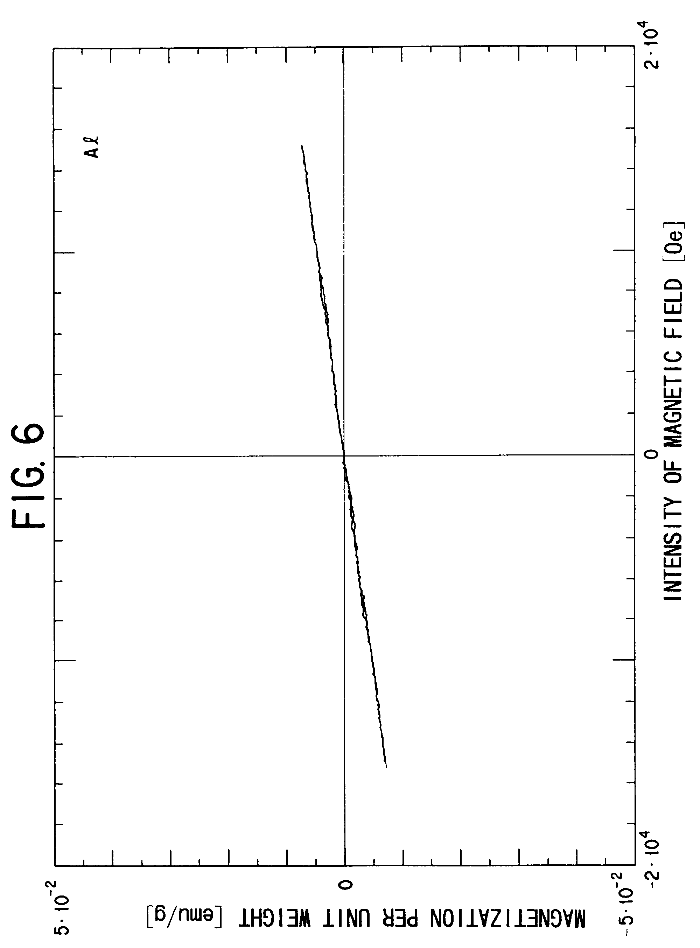

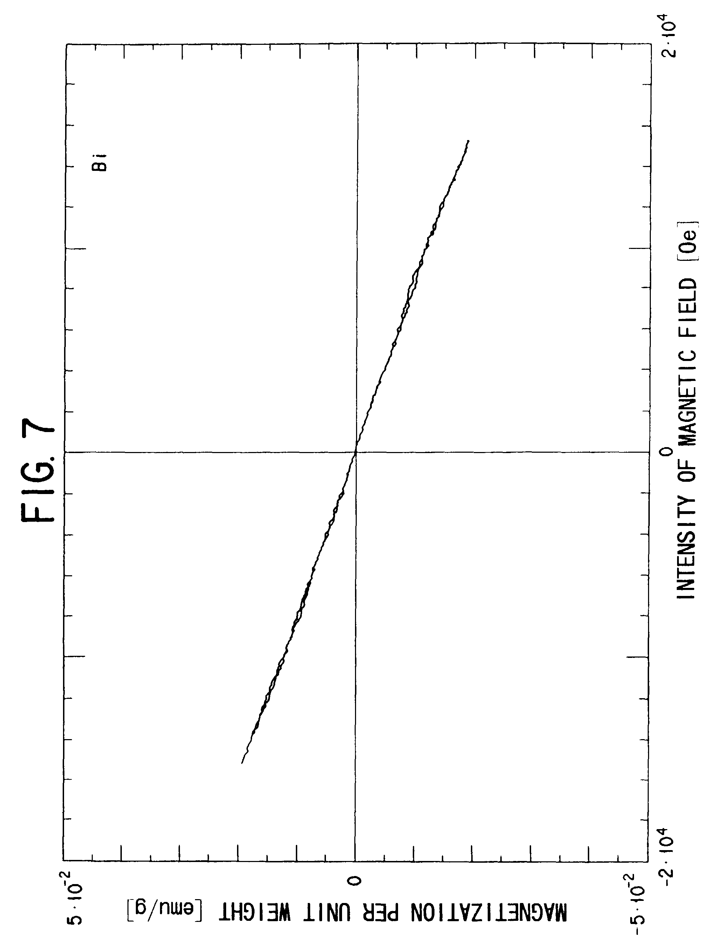

The produced alloy was tested for magnetization by means of a VSM. The results are shown in Fig. 5. The metallic aluminum and the metallic bismuth each of a purity of 99.99% were tested similarly for magnetization by the use of the VSM. The results are shown in Fig. 6 and Fig. 7, respectively.

From the slope of line, about 0.05 x 10⁻² emu/g/15 kOe, shown in Fig. 5, the Al_{94.3} Bi_{5.7} alloy is found to have magnetic susceptibility of about 3 x 10⁻⁸ emu/(g· Oe). From the slopes of lines shown in Fig. 6 and Fig. 7, the metallic aluminum and the metallic bismuth as raw materials are found to have the respective magnitudes, about 0.47 x 10⁻⁶ emu/(g · Oe) and about -1.3 x 10⁻⁶ emu/(g · Oe), of magnetic susceptibility. By alloying aluminum and bismuth in the ratio 94.3 : 5.7 as shown above, the alloy having extremely small and substantially nulled magnetic susceptibility could be produced.

While certain specific working examples have been disclosed herein, the invention may be embodied in other specific forms without departing from the essential characteristics thereof. The described examples are therefore to be considered in all respects as illustrative and not restrictive, the scope of the invention being indicated by the appended claims rather than by the foregoing description and all changes which come within the meaning and range of equivalency of the claims are, therefore, intended to be embraced therein.

## Claims

1. Use of a nonmagnetic material as a sample container or a sample supporting member for a magnetometric apparatus, said nonmagnetic material comprising in combination at least two materials respectively of a positive and a negative magnitude of magnetic susceptibility in a ratio such that said opposite magnitudes of magnetic susceptibility are mutually offset and substantially nullified, said material of positive magnetic susceptibility being selected from the group consisting of Al and Mg and said material of negative magnetic susceptibility being selected from the group consisting of Zn, Ga, Ge, Ag, Bi, In, Al₂O₃ and SiO₂ wherein said material has a combination of paramagnetic material - diamagnetic material selected from the group of 50 % Mg - 50 % Zn, 50 % Mg - 50 % In, 96.6 % Mg - 3.4 Bi, 66 % Mg - 34 % Ag, 68.7 % Mg - 31.3 % Ga, 94.3 % Al - 5.7 % Bi, 37 % Al - 63 % Zn, 56 % Al - 44 % Ga, 35 % Al - 65 % Al₂O₂, and 45 % Al - 55 % SiO₂ respectively expressed in % by weight.

2. The use of a nonmagnetic material according to claim 1, wherein said nonmagnetic material is formed by alloying, dispersing, laminating, or mixing said material of a positive and a negative magnitude of magnetic susceptibility.

## Patentansprüche

1. Verwendung eines nichtmagnetischen Materials als Probenbehälter oder Probenhalteelement für eine magnetometrische Vorrichtung, wobei das nichtmagnetische Material in Kombination zumindest zwei Materialien mit positivem bzw. mit negativem Wert der magnetischen Suszeptibilität in einem solchen Verhältnis beinhaltet, daß sich die entgegengesetzten Werte der magnetischen Suszeptibilität gegenseitig aufheben und im wesentlichen auf 0 bringen, wobei das Material mit positiver magnetischer Suszeptibilität ausgewählt ist aus der Gruppe aus Al und Mg und das Material mit negativer magnetischer Suszeptibilität ausgewählt ist aus der Gruppe aus Zn, Ga, Ge, Ag, Bi, In, Al₂O₃ und SiO₂, wobei das Material eine Kombination aus paramagnetischem Material - diamagnetischem Material aufweist, die ausgewählt ist aus der Gruppe aus 50 % Mg - 50 % Zn, 50 % Mg - 50 % In, 96,6 % Mg - 3,4 Bi, 66 % Mg - 34 % Ag, 68,7 % Mg - 31,3 % Ga, 94,3 % Al - 5,7 % Bi, 37 % Al - 63 % Zn, 56 % Al - 44 % Ga, 35 % Al - 65 % Al₂O₂, und 45 % Al - 55 % SiO₂, jeweils in Gewichtsprozent ausgedrückt.

2. Verwendung eines nichtmagnetischen Materials nach Anspruch 1, wobei das nichtmagnetische Material hergestellt ist durch Legieren, Dispergieren, Laminieren oder Mischen des Materials mit positivem und mit negativem Wert der magnetischen Suszeptibilität.

## Revendications

1. Utilisation d'un matériau amagnétique comme récipient pour échantillons ou comme élément de support d'échantillons pour appareil magnétométrique, ledit matériau amagnétique comprenant en combinaison au moins deux matériaux d'amplitudes de susceptibilité magnétique respectivement positive et négative, dans un rapport tel que lesdites amplitudes opposées de susceptibilité magnétique se compensent mutuellement jusqu'à s'annuler substantiellement, ledit matériau de susceptibilité magnétique positive étant choisi dans le groupe constitué de Al et Mg et ledit matériau de susceptibilité magnétique négative étant choisi dans le groupe constitué de Zn, Ga, Ge, Ag, Bi, In, Al₂O₃ et SiO₂ dans lequel ledit matériau présente une combinaison matériau paramagnétique - matériau diamagnétique choisie dans le groupe constitué de 50 % Mg - 50 % Zn, 50 % Mg - 50 % In, 96,6 % Mg - 3,4 % Bi, 66 % Mg - 34 % Ag, 68,7 % Mg - 31,3 % Ga, 94,3 % Al - 5,7 % Bi, 37 % Al - 63 % Zn, 56 % Al - 44 % Ga, 35 % Al - 65 % Al₂O₂, et 45 % Al - 55 % SiO₂ exprimées respectivement en % en poids.

2. Utilisation d'un matériau amagnétique selon la revendication 1, dans lequel ledit matériau amagnétique est formé en alliant, en dispersant, en laminant, ou en mélangeant lesdits matériaux d'amplitudes de susceptibilité magnétique positive et négative.
